(19) **Europäisches Patentamt European Patent Office Office européen des brevets**

(11) **EP 1 766 422 B1**

(12) **FASCICULE DE BREVET EUROPEEN**

(45) Date de publication et mention de la délivrance du brevet:
**28.02.2018 Bulletin 2018/09**

(21) Numéro de dépôt: **05783755.1**

(22) Date de dépôt: **30.06.2005**

(51) Int Cl.:
*G01R 15/20* *(2006.01)*    *G01R 31/00* *(2006.01)*

(86) Numéro de dépôt international:
**PCT/FR2005/001664**

(87) Numéro de publication internationale:
**WO 2006/010865 (02.02.2006 Gazette 2006/05)**

(54) **PROCEDE DE MESURE DU COURANT ELECTRIQUE DANS UNE PLURALITE DE CONDUCTEURS**

VERFAHREN ZUM MESSEN VON ELEKTRISCHEM STROM IN EINER VIELZAHL VON LEITERN

METHOD FOR MEASURING ELECTRIC CURRENT IN A PLURALITY OF CONDUCTORS

(84) Etats contractants désignés:
**AT BE BG CH CY CZ DE DK EE ES FI FR GB GR HU IE IS IT LI LT LU MC NL PL PT RO SE SI SK TR**

(30) Priorité: **30.06.2004 FR 0407261**

(43) Date de publication de la demande:
**28.03.2007 Bulletin 2007/13**

(73) Titulaire: **VALEO EQUIPEMENTS ELECTRIQUES MOTEUR**
**94017 Créteil-Cedex (FR)**

(72) Inventeurs:
• **CHEMIN, Michaël**
**51700 Festigny (FR)**
• **LEROUX, Frédéric**
**94000 Créteil (FR)**
• **BERNARD, François-Xavier**
**94000 Créteil (FR)**

(74) Mandataire: **de Lambilly Delorme, Marie Pierre**
**Valéo Equipements Electriques Moteur**
**Propriété Industrielle**
**2, rue André-Boulle**
**94046 Créteil Cedex (FR)**

(56) Documents cités:
**EP-A- 0 597 404    EP-A- 0 947 843**
**DE-A1- 2 845 155    DE-U1- 29 804 737**
**US-A- 4 418 312    US-A- 4 933 630**
**US-A- 5 907 244    US-B1- 6 472 878**
**US-B1- 6 583 613**

## Description

### Domaine de l'invention

La présente invention concerne un procédé de mesure d'un courant électrique dans une pluralité de conducteurs ainsi qu'un dispositif pour la mise en oeuvre d'un tel procédé.

L'invention trouve une application particulièrement avantageuse dans le domaine des machines électriques tournantes utilisées dans l'industrie automobile.

### Etat de la technique

Les véhicules automobiles à moteur thermique peuvent être équipés de machines électriques réversibles, appelées également alterno-démarreurs, fonctionnant aussi bien en mode alternateur qu'en mode moteur au démarrage ou en aide au décollage (« boost ») à partir de 500 tours/mn pour le moteur thermique.

La machine électrique réversible comprend une unité de puissance et une unité de contrôle, ladite unité de puissance fait office d'onduleur de courants en mode démarreur et de redresseur de courants en mode alternateur et est commandée par l'unité de contrôle.

Dans ce type de machines, il est nécessaire de pouvoir contrôler à tout moment le couple fourni ou prélevé par l'alterno-démarreur. Or, ce couple dépend directement du courant du stator de la machine, et plus précisément des courants aux différentes phases du stator lorsque celui-ci fonctionne en courant multiphasé, par exemple triphasé. Afin de contrôler et par suite réguler les différents courants statoriques, il existe donc une unité de régulation de courant qui est généralement numérique.

Dans la machine, ces courants traversent des conducteurs généralement de forte section placés entre le stator et un redresseur, ou onduleur sur l'unité de puissance.

Ces conducteurs sont par exemple des conducteurs rectilignes parallèles désignés sous le nom de « bus barres ».

On comprend alors l'intérêt, pour un pilotage de l'alterno-démarreur le mieux approprié au fonctionnement du moteur du véhicule, de connaître avec précision les courants traversant les n bus barres, n étant égal à 3 dans les machines triphasées.

Pour déterminer les courants du stator, on a recours à différents types de dispositifs connus.

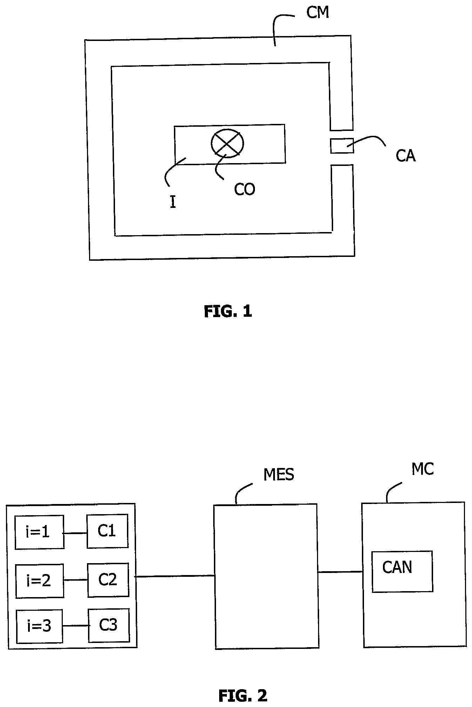

La Figure 1 est une vue de côté d'un dispositif connu utilisant un circuit magnétique CM en ferrite entourant chaque conducteur CO et se refermant sur un capteur CA à effet Hall qui mesure le champ magnétique produit par le courant I traversant le conducteur CO, le capteur étant en regard du circuit magnétique. Un tel dispositif est fixé sur un dissipateur de l'unité de puissance de l'alterno-démarreur.

Cependant, ces dispositifs sont coûteux, encombrants et de mise en oeuvre complexe puisqu'ils exigent, d'une part, une liaison connecteur entre le capteur et l'unité de contrôle couramment appelée carte de contrôle, et, d'autre part, de faire passer chaque conducteur ou bus barre à travers un circuit magnétique en ferrite.

On connaît aussi des dispositifs à base de shunts électriques qui ne sont toutefois pas bien adaptés si on veut mesurer des courants très intenses (800 A par exemple) avec peu de pertes par effet Joule. De plus, il existe des problèmes de connexion sur les conducteurs. Enfin, dans le cas de valeurs de shunts faibles il y a beaucoup d'imprécision au niveau des mesures des courants faibles. Les documents DE 298 04 737 U et US-6,472,878 B divulguent des dispositifs de mesure de courants électriques dans une pluralité de conducteurs rigides et parallèles inclus dans une unité de puissance, lesdits dispositifs comprenant des transducteurs de courant électrique sous la forme de capteurs de champ magnétique. Les documents EP-0 597 404 A, US-6,583,613 B, US-4,933,630 A, EP 0 947843 A et DE 28 45 155 A divulguent des dispositifs comprenant des transducteurs de courant électrique sous la forme de capteurs de champ magnétique pour mesurer des courants dans plusieurs conducteurs et comprenant aussi des moyens pour corriger l'influence du champ magnétique des conducteurs voisins.

### Objet de l'invention

Aussi, un problème technique à résoudre par l'objet de la présente invention est de proposer un dispositif de mesure du courant électrique dans une pluralité de conducteurs, qui serait bon marché, sans pertes et de mise en oeuvre aisée, tout en garantissant une détermination précise des courants recherchés.

La solution au problème technique posé est définie par le dispositif selon la revendication 1. Ainsi, le dispositif conforme à l'invention ne nécessite l'utilisation que de simples transducteurs de champ magnétique sans circuit magnétique, les transducteurs étant des capteurs de champ magnétique, préférentiellement tels que des capteurs à effet Hall, peu encombrants. Aucune dissipation d'énergie par effet Joule ne peut se produire, et la mesure du courant dans chaque conducteur est précise et reproductible, la matrice de décorrélation ne mettant en jeu que des paramètres fixes définitivement déterminés par la disposition respective des transducteurs par rapport aux conducteurs électriques associés.

Selon l'invention, la matrice de décorrélation comporte des éléments qui sont déterminés en appliquant successivement dans chaque conducteur un courant calibré, le courant appliqué dans les autres conducteurs étant nul, et en mesurant au moyen desdits transducteurs un signal de courant électrique associé à chaque conducteur. Les courants réels se déduisent alors des courants mesurés en appliquant la matrice inverse de la matrice de décorrélation.

La précision de la mesure peut encore être augmentée en cas de décalages (« offset ») sur les courants dus notamment aux imprécisions des capteurs et du circuit de mesure desdits courants, si le dispositif conforme à l'invention comporte en outre un moyen de détermination d'une matrice de décalage dont les éléments sont égaux aux courants mesurés dans chaque conducteur en l'absence de courants appliqués dans lesdits conducteurs, les courants réels étant déduits des courants mesurés au moyen de la matrice de décorrélation et de ladite matrice de décalage.

Alors, une matrice de courants réels est obtenue en en soustrayant la matrice de décalage à une matrice des courants mesurés et en appliquant la matrice inverse de la matrice de décorrélation au résultat obtenu.

Enfin, dans une utilisation du dispositif, objet de l'invention, à la mesure du courant électrique dans les conducteurs d'entrée/sortie des pôles d'un stator d'une machine électrique tournante, l'invention prévoit qu'une matrice de projection inverse est multipliée par la matrice inverse d'une matrice de décorrélation pour réaliser une matrice unique appliquée aux courants mesurés de sortie du stator afin de réaliser une régulation numérique de courants de ladite machine électrique tournante.

Cette dernière disposition présente l'avantage que le traitement de régulation numérique inclut au moyen d'une matrice unique à la fois la mesure des courants (matrice inverse da la matrice de décorrélation) et une transformation permettant de passer d'un repère n-phasé à un repère biphasé (matrice de projection inverse).

### Brève description des Figures

La description qui va suivre en regard des dessins annexés, donnés à titre d'exemples non limitatifs, fera bien comprendre en quoi consiste l'invention et comment elle peut être réalisée.

La Fig. 1 est un schéma d'un dispositif de mesure de courant selon l'état de la technique antérieur,
La Fig. 2 est un schéma du dispositif de mesure de courant pour la mise en oeuvre du procédé conforme à l'invention,
La Fig. 3 est une vue partielle de côté du dispositif de la Figure 2,
La Fig. 4 est un schéma d'une application du procédé conforme à l'invention à la mesure du courant électrique dans les conducteurs d'entrée/sortie des pôles d'un stator d'une machine électrique tournante, et
La Fig. 5 représente la projection de trois courants triphasés dans un système de courants diphasés selon un mode de réalisation du procédé de la Fig. 4.

### Description détaillée de modes de réalisation préférentiels de l'invention

Sur la Figure 2 est représenté un dispositif destiné à la mesure du courant électrique dans n conducteurs repérés, chacun, par la lettre i.

Ce dispositif comporte :

- des capteurs $C_i$ destinés à mesurer le champ magnétique correspondant à chacun des n conducteurs,
- un circuit MES de mesure de la tension correspondant à chaque courant électrique traversant les conducteurs i, ce circuit étant destiné à transposer la tension mesurée aux bornes des capteurs $C_i$ d'une première référence (par exemple -10V, + 10V) en une deuxième référence (par exemple 0V-5V), et
- un microcontrôleur MC de gestion de mesure destiné notamment à asservir les courants du stator, ledit microcontrôleur comprenant un convertisseur analogique-numérique CAN destiné à convertir la mesure transposée (entre 0V-5V) issue du circuit MES de mesure en une unité numérique sur préférentiellement 8, 10 ou 12 bits (ce qui correspond à 256, 512 ou encore 1024 points).

Dans le cas représenté sur la Figure 2, les conducteurs sont au nombre de 3 (n=3). Cette situation se produit, par exemple, lorsque le dispositif représenté, ainsi que le procédé qu'il met en oeuvre, sont appliqués à la mesure du courant électrique dans les conducteurs reliés aux pôles d'un stator d'une machine électrique réversible triphasée appelée aussi alterno-démarreur. Les conducteurs i sont par exemple les bus barres du stator appelés en anglais « bus bars ». Ils peuvent également être des câbles ou tiges ou tout autre type de conducteurs de courants, préférentiellement rigides. Le caractère rigide permet notamment d'obtenir une matrice de décorrélation stable et fixée une fois pour toute, matrice que nous allons voir en détail plus loin.

Le procédé de mesure associé au dispositif de la Figure 2 comprend les étapes suivantes.

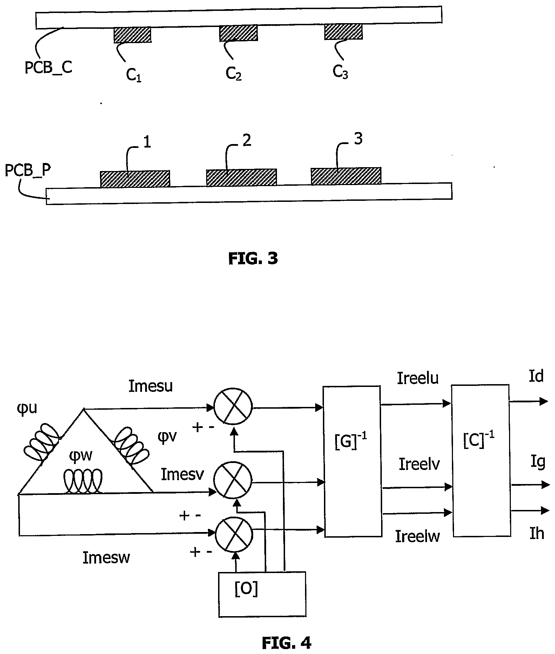

**Dans une première étape,** on place un transducteur $C_i$ de courant électrique, sensiblement en regard de chaque conducteur i (i=1, 2, 3) comme indiqué à la Figure 3. Préférentiellement, le transducteur $C_i$ est un capteur de mesure de champ magnétique tel qu'un capteur à effet Hall. L'avantage d'un capteur à effet Hall est de permettre de mesurer de grandes plages de valeurs de champ magnétique et ce avec beaucoup de précision. De plus, il permet à partir d'un courant mesuré de fournir une grandeur proportionnelle audit courant mesuré effectif et donc représentative dudit courant mesuré effectif, soit une tension, un fréquence ou un courant par exemple.

Préférentiellement, chaque conducteur i, ou bus barre, est placé sur la carte de puissance PCB_P. Avantageusement, chaque transducteur ou capteur $C_i$ est placé sensiblement en regard de chaque conducteur i sur la carte de contrôle PCB_C. Bien entendu, on place les capteurs $C_i$ de manière à ce qu'ils ne saturent pas sur la plage de mesures.

Ainsi, les capteurs n'étant plus sur le dissipateur de la carte de puissance, et étant directement placés sur la carte de contrôle, il n'y a plus besoin de connectique pour les relier du dissipateur à la carte de contrôle. Ceci a pour avantage d'éliminer des problèmes de fiabilité et des problèmes de contraintes mécaniques dues à une connectique encombrante et coûteuse, les contraintes mécaniques étant souvent dépendantes de vibrations provenant du véhicule par exemple.

De même, les transducteurs $C_i$ n'étant plus placés dans un circuit magnétique de ferrite comme dans l'art antérieur de la Figure 1, le champ magnétique circulant dans chaque conducteur i n'est plus canalisé par ledit circuit magnétique. En conséquence, il peut se produire des effets de bords, en ce sens qu'un transducteur $C_i$ sera aussi bien sensible au champ magnétique du conducteur i associé disposé en regard qu'aux champs magnétiques des deux autres conducteurs i. Ce problème est résolu de la manière suivante.

**Dans un deuxième temps,** lors d'une étape d'initialisation, on applique un courant calibré $I_j^0$ à un conducteur j, aucun courant n'étant appliqué dans les autres conducteurs i (i≠j), puis on mesure au moyen de chaque transducteur $C_i$ un signal de courant $I_i$ associé. Le courant $I_i$ équivalent mesuré n'est pas nul pour les conducteurs i (i≠j) du fait que les transducteurs $C_i$ (i≠j) détectent le champ magnétique produit par le courant $I_j^0$ dans le conducteur j et fournissent donc un signal de courant électrique correspondant à ce champ magnétique. On peut par exemple prendre un courant calibré $I_j^0$ équivalent au courant maximum que peut supporter l'onduleur, par exemple 1000 ampères. Dans un autre exemple on peut prendre une valeur de courant calibré $I_j^0$ facilitant la gestion par le microcontrôleur de gestion MC, par exemple une puissance de 2. Dans le cas d'une puissance de 2, on peut prendre par exemple la valeur de 819,2 ampères pour une résolution de 0,1 Ampère, ce qui correspond à $8192 = 2^{13}$. Ainsi, cela facilite le calcul de la division qui suit, car à ce moment, le microcontrôleur n'effectue que des décalages. Bien entendu comme expliqué précédemment, selon le capteur $C_i$, le signal de courant $I_i$ est une grandeur pouvant être exprimée en courant, tension, fréquence..., ce signal de courant $I_i$ étant représentatif du courant mesuré effectif lorsque aucun courant n'est appliqué sur les autres conducteurs.

On en déduit n éléments $G_{ij}$ d'une matrice [G] de décorrélation, j étant fixé et i variable de 1 à n, par la relation : $G_{ij} = I_i/I_j^0$ **[1]**. Dans le cas de trois conducteurs, on déduit les éléments $G_{11}$, $G_{21}$ et $G_{31}$ de l'application d'un courant $I_1^0$ dans le conducteur i=1 et de la mesure des courants $I_1$, $I_2$ et $I_3$ :

$$I_1 = G_{11}.I_1^0$$

$$I_2 = G_{21}.I_1^0$$

$$I_3 = G_{31}.I_1^0$$

Effectuant n fois cette même opération en appliquant à chaque conducteur un courant calibré, on en déduit les $n^2$ éléments $G_{ij}$ de la matrice [G].

Pour 3 conducteurs, la matrice [G] s'écrit :

$$[G] = \begin{vmatrix} G_{11} & G_{12} & G_{13} \\ G_{21} & G_{22} & G_{23} \\ G_{31} & G_{32} & G_{33} \end{vmatrix}$$

Cette matrice [G] de décorrélation, ainsi que sa matrice inverse $[G]^{-1}$ sont ainsi calculées par le microcontrôleur MC et sauvegardées dans une de ses mémoires, par exemple réinscriptible EEPROM (non représentée).

En mode de fonctionnement normal sur un véhicule, on mesure les courants $I_{mesi}$ dans chaque conducteur i au moyen des transducteurs $C_i$ de courant électrique pour en déduire les courants réels $I_{réelj}$ par la relation matricielle : $[I_{réel}]=[G]^{-1}[I_{mes}]$.

La matrice [G] est donc de nature essentiellement géométrique, elle tient compte en particulier de possibles tolérances de montage des capteurs, notamment la dispersion sur les distances entre les bus barres et les capteurs

Ainsi, cette matrice [G] de décorrélation permet de limiter l'influence des courants extérieurs au courant à mesurer et par conséquent du champ magnétique mesuré par un capteur $C_i$.

Dans le cas de l'application aux courants des trois phases u, v, w du stator d'une machine électrique réversible, on obtient les courants réels à partir des courants mesurés par :

$$\begin{vmatrix} I_{réelu} \\ I_{réelv} \\ I_{réelw} \end{vmatrix} = [G]^{-1} \begin{vmatrix} I_{mesu} \\ I_{meslv} \\ I_{mesw} \end{vmatrix}$$

Préférentiellement, le procédé de calcul de mesure de courant comporte une étape supplémentaire de calibration permettant également de tenir compte de décalages appelés « offset » en anglais qui sont dus aux imprécisions de mesure induites notamment par :

- les capteurs Ci,
- les composants du circuit MES de mesure,
- les composants du convertisseur analogique-numérique CAN du microcontrôleur MC.

Par exemple, le convertisseur CAN sera précis à 1 bit près correspondant à plus ou moins 0.5 A si la mesure est convertie sur 12 bits pour une plage de mesure de plus ou moins 1000A ($2000/2^{12} = 0.5$). Pour une plage de mesure de plus ou moins 100A, le convertisseur CAN sera précis à 1 bit près correspondant à plus ou moins 0.05 A si la mesure est convertie sur 12 bits.

Ainsi, on tient compte des décalages au moyen d'une matrice [O] de décalage dont les éléments $O_1$ sont égaux aux courants mesurés dans chaque conducteur i en l'absence de courants appliqués dans lesdits conducteurs, la matrice $[I_{réel}]$ de courants réels est alors donnée par : $[I_{réel}]=[G]^{-1}([I_{mes}]-[O])$.

Les éléments $O_1$ peuvent être également des valeurs numériques correspondant aux courants mesurés.

Dans le cas de trois conducteurs, la matrice [O] de décalage s'écrit :

$$[O] = \begin{vmatrix} O_1 \\ O_2 \\ O_3 \end{vmatrix}$$

Cette matrice [O] est aussi calculée par le microcontrôleur MC et sauvegardée dans une de ses mémoires par exemple réinscriptible EEPROM (non représentée).

Lorsque cette étape de calibration est prise en compte, la matrice de décorrélation [G] est calculée selon la relation suivante :

$$G_{ij}= (I_i-Oi)/I_j^0 \ \textbf{[2]},$$

avec Oi correspondant au décalage du courant mesuré $I_i$, i ($i \neq j$) lors de l'étape d'initialisation.

Notons que les matrices [G] et [O] peuvent intégrer respectivement les différents gains de la chaîne et des décalages, ce qui permet de recentrer les signaux à une valeur correspondant au zéro.

Ainsi, dans le cas où on ne prendrait en compte que les décalages dus aux capteurs, la matrice [G] de décorrélation sera exprimée en ohms et par suite la matrice inverse $[G]^{-1}$ en siemens. Un exemple d'une telle matrice est donné ci-après avec chaque capteur $C_i$ maintenu à une distance d'environ 2,5 cm à la verticale de leur bus barre i associé et un premier capteur $C_1$ étant à une distance diagonale de 5,5 cm par rapport au deuxième bus barre 2 et à une distance diagonale de 10,5 cm par rapport au troisième bus barre 3 :

.

$$[G]^{-1} = \begin{vmatrix} 4021 & -1250 & -156 \\ -972 & 4212 & -972 \\ -79 & -864 & 3981 \end{vmatrix}$$

avec une matrice [O] de décalage correspondante égale à :

$$[O] = \begin{vmatrix} 0{,}00053 \\ -0{,}00138 \\ 0{,}00015 \end{vmatrix}$$

Bien entendu, on calibrera de préférence tout le dispositif de mesure de courant à savoir les capteurs, le circuit de mesure et le convertisseur analogique-numérique. Dans ce cas, l'unité de la matrice [G] de décorrélation sera en unité microcontrôleur par ampères.

Ainsi, selon la calibration, un courant réel $I_{réel}$ aura une unité différente. L'unité pourra, par exemple, être une tension si la calibration ne porte que sur les capteurs $C_i$, une fréquence si la calibration porte sur les capteurs $C_i$ et le circuit de mesure MES, un nombre numérique avec une résolution si la calibration porte sur les capteurs $C_i$, le circuit de mesure MES et le convertisseur analogique-numérique MC par exemple.

Ainsi, la matrice [G] de décorrélation que l'on peut également appeler matrice Gain et la matrice [O] de décalage que l'on peut appeler également matrice d'Offset permettent de calibrer l'ensemble du dispositif de mesure des courants en résolvant le problème des capteurs corrélés et des imprécisions dues aux composants de l'ensemble du dispositif de mesure, ce qui n'aurait pas pu se faire en utilisant uniquement des vecteurs simples de décorrélation ou d'offsets.

La Figure 4 montre comment l'invention peut être appliquée à la régulation numérique des courants triphasés $I_u$, $I_v$ et $I_w$ du stator d'une machine réversible.

Dans un mode de réalisation non limitatif, le procédé de mesure de courant comporte une étape supplémentaire de transformation des courants réels $I_{réel}$ mesurés d'un repère n-phasé dans un repère biphasé au moyen d'une matrice [C] de projection.

Cette étape supplémentaire est effectuée pour simplifier les calculs et la façon d'asservir les courants dans les phases $\varphi$ du stator de la machine alterno-démarreur.

Dans le cas de n=3, les courants sont traités par des matrices telles qu'une matrice connue sous le nom de matrice de Concordia ou une autre sous le nom de matrice de Clark, transformant les courants triphasés $I_u$, $I_v$ et $I_w$ en courants diphasés $I_\alpha$ et $I_\beta$. Ces courants diphasés sont appliqués par la suite à l'unité de régulation numérique pour réguler les courants statoriques. Ainsi, on obtient :

$$\begin{vmatrix} I_\alpha \\ I_\beta \\ I_h \end{vmatrix} = [C]^{-1} \begin{vmatrix} I_u \\ I_v \\ I_w \end{vmatrix}$$

où $I_h$ est une composante homopolaire, soit $[I_{régul}] = [C]^{-1} [I_{réel}]$

On notera que la composante homopolaire correspond à la somme des courants triphasés sur un 3<sup>ème</sup> axe qui est perpendiculaire à l'axe O$\beta$.

Dans le cas d'un bobinage des phases en triangle bien connu de l'homme du métier, la composante homopolaire correspond à un courant de circulation interne.

Dans le cas d'un bobinage des phases en étoile bien connu de l'homme du métier, la composante homopolaire correspond au point neutre du stator qui est le point commun entre les trois phases. Si le point neutre n'est pas connecté, la composante homopolaire est neutre.

Cette matrice [C] ainsi que sa matrice inverse $[C]^{-1}$ sont sauvegardées dans une des mémoires du microcontrôleur MC, par exemple non réinscriptible ROM ou réinscriptible EEPROM (non représentées).

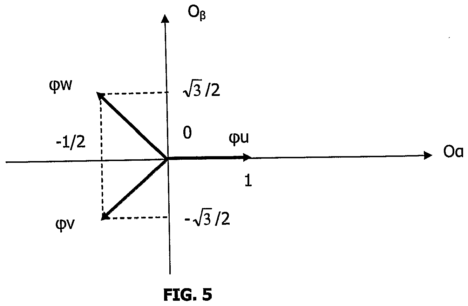

La Figure 5 représente la projection des trois courants triphasés $I_u$, $I_v$ et $I_w$ dans le système ($\alpha$, $\beta$, 0) en prenant l'axe de la première phase $\varphi_u$ du stator, auquel correspond le courant $I_{mesu}$, pour repérer les angles.

Selon un exemple de matrice de projection Concordia applicable, on a :

$$[C] = \sqrt{(2/3)} \begin{vmatrix} 1 & 0 & 1/\sqrt{2} \\ -1/2 & (\sqrt{3})/2 & 1/\sqrt{2} \\ -1/2 & -(\sqrt{3})/2 & 1/\sqrt{2} \end{vmatrix}$$

et

$$[C]^{-1} = \sqrt{(2/3)} \begin{vmatrix} 1 & -1/2 & -1/2 \\ 0 & \sqrt{3}/2 & -\sqrt{3}/2 \\ 1/\sqrt{2} & 1/\sqrt{2} & 1/\sqrt{2} \end{vmatrix}$$

Selon un exemple de matrice de projection Clark applicable, on a :

$$[C] = \begin{vmatrix} 1 & 0 & 1 \\ -1/2 & -(\sqrt{3})/2 & 1 \\ -1/2 & (\sqrt{3})/2 & 1 \end{vmatrix}$$

et

$$[C]^{-1} = 2/3 \begin{vmatrix} 1 & -1/2 & -1/2 \\ 0 & -(\sqrt{3})/2 & (\sqrt{3})/2 \\ 1/2 & 1/2 & 1/2 \end{vmatrix}$$

On notera que les coefficients de ces matrices de projection sont constants mais sont fonction de conventions telles que le sens de rotation pris des courants triphasés, l'intensité de ses courants.... Aussi, on peut avoir un facteur de normalisation différent.

Ainsi, on peut voir que les courants diphasés $I_\alpha$ et $I_\beta$ peuvent être directement obtenus à partir des courants mesurés $I_{mes}$ par le dispositif de la Figure 2 au moyen d'une matrice unique [M] qui s'écrit : $[M]=[C]^{-1}. [G]^{-1}= [G.C]^{-1}$

On a alors la relation suivante :

$$[I_{\alpha, \beta}] = [M].([I_{mes}]-[O])$$

On notera que les produits des deux matrices $[G]^{-1}$ et $[C]^{-1}$ s'effectue hors ligne, en ce sens qu'on ne prend pas en compte la rotation de la machine et donc l'angle $\theta$ stator-rotor.

Dans le cas où l'on veut travailler dans le repère de la machine, c'est à dire prendre en compte l'angle $\theta$ stator-rotor et donc faire un calcul des courants en ligne, à savoir en temps réel, on suppose les axes $O\alpha$ et $O\beta$ décalés de l'angle $\theta$ par rapport à l'axe de la première phase $\varphi_u$. Les nouveaux axes sont l'axe direct $O_d$ et l'axe en quadrature Oq bien connus de l'homme du métier. Ainsi, on passe du système ($\alpha$, $\beta$, 0) au système (d, q, O) par application d'une matrice de rotation [R] :

$$[R]= \begin{vmatrix} \cos\theta & \sin\theta & 0 \\ -\sin\theta & \cos\theta & 0 \\ 0 & 0 & 1 \end{vmatrix}$$

On a ainsi :

$$\begin{vmatrix} x_\alpha \\ x_\beta \\ 0 \end{vmatrix} = [R] \begin{vmatrix} x_d \\ x_q \\ 0 \end{vmatrix}$$

Soit,

$$\begin{vmatrix} X_d \\ X_q \\ 1 \end{vmatrix} = [R]^{-1} \begin{vmatrix} x_\alpha \\ x_\beta \\ 1 \end{vmatrix}$$

On utilise une transformation connue sous le nom de Park [P] qui est le produit de la matrice de projection (Concordia ou Clark) et de la matrice de rotation [R].

$$P = \begin{vmatrix} \cos\theta & \sin\theta & 1 \\ \cos(\theta - 2\pi/3) & \sin(\theta - 2\pi/3) & 1 \\ \cos(\theta - 4\pi/3) & \sin(\theta - 4\pi/3) & 1 \end{vmatrix}$$

On applique ainsi la matrice inverse Park $[P]^{-1} = [R]^{-1}.[C]^{-1}$ aux courants mesurés $I_{mes}$ pour obtenir de nouveaux courants $I_{dq}$ en incluant le cas échéant la matrice [O] de décalage. On obtient ainsi

$$\begin{aligned}[I_{dq}] &= [P]^{-1}. [G]^{-1}.([I_{mes}]-[O]) \\ &= [R]^{-1}. [C]^{-1}. [G]^{-1}.([I_{mes}]-[O]) \\ &= [R]^{-1}. [M].([I_{mes}]-[O]) \end{aligned}$$

Cette transformation de Park permet d'obtenir un asservissement des courants de la machine plus performant. On obtient ainsi des grandeurs continues au lieu de grandeurs variables ou alternatives, les grandeurs continues étant plus facile à réguler.

On notera qu'avant le fonctionnement normal de l'onduleur-redresseur, les matrices [G], [O] et [M] sont calculées par le microcontrôleur MC une fois pour toute.

Ainsi, le procédé de mesure de courants présente un avantage certain par rapport à un calcul théorique de la matrice de décorrélation faite par un calculateur, ce dernier ne connaissant pas les perturbations dues par exemple aux composants voisins des capteurs et les imprécisions dues aux capteurs. De plus, le procédé de l'invention est plus simple qu'un calcul par un calculateur. Enfin, le procédé selon l'invention permet une décorrélation complète des mesures de courants dans les différents conducteurs. On notera que cette décorrélation est différente d'une décorrélation entre un flux et un courant mesurés dans un conducteur, décorrélation qui poursuit un but différent de la décorrélation des courants.

On notera que le procédé selon l'invention est applicable non seulement à une mesure de courants dans une machine électrique tournante mais également dans toute application dans laquelle une mesure sur une pluralité de courants est nécessaire dans un espace restreint entraînant une corrélation entre les mesures et donc nécessitant une décorrélation comme par exemple un système de gestion de batterie couramment appelé BMS d'une automobile ou un convertisseur DC/DC. En effet, un système de gestion de batterie comporte généralement un boîtier comprenant différents connecteurs sur lesquels sont connectés une batterie, et des consommateurs tels qu'une climatisation ou un système de gestion de hi-fi. Pour le bon fonctionnement de ladite batterie et desdits consommateurs il convient de mesurer les courants les traversant.

De même, un convertisseur de tension DC/DC comporte différentes cellules de composants dans lesquelles transitent des courants ainsi qu'un courant d'entrée et un courant de sortie qu'il faut mesurer. On notera qu'un convertisseur DC/DC peut être utilisé dans un véhicule 42V dans lequel la batterie est à 42V et les consommateurs sont à 12V, ledit convertisseur permettant de passer du 42V au 12V.

## Revendications

1. Dispositif de mesure de courants électriques dans une pluralité de n conducteurs rigides, rectilignes et parallèles (i, i=1,...,n) inclus dans une carte de puissance (PCB_P) et situés dans un premier plan défini par celle-ci, ledit dispositif comprenant des transducteurs de courant électrique ($C_i$) sous la forme de capteurs de champ magnétique et un microcontrôleur (MC) contenant en mémoire des matrices de calcul ([G], [O]) autorisant un calcul des courants électriques réels ($I_{réeli}$) circulant dans ladite pluralité de n conducteurs (i, i=1,...,n) à partir de courants mesurés ($I_{mesi}$) au moyen desdits transducteurs ($C_i$), le dispositif comportant une carte de contrôle (PCB_C) incluant n dits transducteurs ($C_i$) situés dans un second plan défini par celle-ci et correspondant respectivement aux n dits conducteurs (i, i=1,...,n), ladite carte de contrôle (PCB_C) étant prévue pour être montée, en position de mesure, parallèlement à ladite carte de puissance (PCB_P) de manière à ce que lesdits transducteur ($C_i$) soient placés en regard desdits conducteurs respectifs (i, i=1,...,n) et avec lesdits premier et second plans disposés parallèlement, et ledit microcontrôleur (MC) comportant :

   - des moyens pour construire au moins une matrice de décorrélation ([G]) entre lesdits courants mesurés ($I_{mesi}$) et lesdits courants réels ($I_{réeli}$) en fonction de la position des transducteurs ($C_i$) par rapport auxdits conducteurs (i) ;
   - des moyens pour construire une matrice de décalage ([O]) en déterminant ses éléments ($O_i$) comme égaux aux courants mesurés dans chaque conducteur (i) en l'absence de courants appliqués dans lesdits conducteurs, et
   - des moyens pour calculer une matrice de courant réels ([$I_{réel}$]) représentant lesdits courants réels ($I_{réeli}$) en soustrayant ladite matrice de décalage ([O]) à une matrice ([$I_{mes}$]) des courants mesurés ($I_{mesi}$) et en appliquant une matrice inverse ([G]$^{-1}$) de la matrice de décorrélation ([G]) au résultat obtenu.

2. Dispositif selon la revendication 1, **caractérisé en ce que** ladite matrice de décorrélation ([G]) comportent des éléments ($G_{ij}$) qui sont déterminés en appliquant successivement dans chaque conducteur (j) un courant calibré ($I_{j0}$), le courant appliqué dans les autres conducteurs étant nul, et en mesurant au moyen desdits transducteurs ($C_i$) un signal de courant électrique ($I_i$) associé à chaque conducteur (i).

3. Dispositif selon la revendication 1 ou 2, **caractérisé en ce que** lesdits capteurs de champ magnétique sont des capteurs à effet Hall.

4. Utilisation du dispositif selon l'une quelconque des revendications 1 à 3 pour la mesure du courant électrique dans des conducteurs d'entrée/sortie des pôles d'un stator d'une machine électrique tournante.

5. Utilisation selon la revendication 4, **caractérisée en ce qu'**une matrice ([C]$^{-1}$) de projection inverse est multipliée par ladite matrice inverse ([G]$^{-1}$) de la matrice de décorrélation pour réaliser une matrice unique ([M]= [C]$^{-1}$. [G]$^{-1}$) appliquée aux courants mesurés de sortie du stator afin de réaliser une régulation numérique de courants de ladite machine électrique tournante.

6. Utilisation selon la revendication 5, **caractérisée en ce que**, préalablement à l'application de la matrice unique ([M]) aux courants mesurés, ladite matrice de décalage ([O]) est appliquée aux courants mesurés de sortie du stator.

7. Utilisation du dispositif selon l'une quelconque des revendications 1 à 3 pour la mesure du courant électrique dans un système de gestion de batterie.

8. Utilisation du dispositif selon l'une quelconque des revendications 1 à 3 pour la mesure du courant électrique dans un système de convertisseur de tension (DC/DC).

**Patentansprüche**

1. Vorrichtung zum Messen von elektrischen Strömen in einer Vielzahl von n starren, geradlinigen und parallelen Leitern (i, i = 1, ..., n), die in einer eine Leistungskarte (PCB_P) enthalten sind und in einer ersten Ebene angeordnet sind, die durch diese definiert ist, wobei die Vorrichtung Stromwandler ($C_i$) in Form von Magnetfeldsensoren und einen Mikrocontroller (MC) aufweist, der im Speicher Berechnungsmatrizen ([G], [0]) enthält, die ein Berechnen der tatsächlichen elektrischen Ströme ($I_{réeli}$), die in der Vielzahl von n Leitern (i, i = 1, ..., n) fließen, ausgehend von Strömen ($I_{mesi}$), die mittels der Wandler ($C_i$) gemessen werden, ermöglichen,
   wobei die Vorrichtung eine Steuerkarte (PCB_C) aufweist, die n Wandler ($C_i$) aufweist, die in einer zweiten Ebene angeordnet sind, die durch diese definiert ist, und jeweils den n Leitern (i, i = 1, ..., n) entsprechen, wobei die Steuerkarte (PCB_C) vorgesehen ist, um in Messposition parallel zu der Leistungskarte (PCB_P) derart befestigt zu werden, dass die Wandler ($C_i$) den jeweiligen Leitern (i, i = 1 ,..., n) gegenüberliegend angeordnet sind und wobei die erste und die zweite Ebene parallel angeordnet sind, und
   wobei der Mikrocontroller (MC) Folgendes aufweist:

   - Mittel zum Erstellen von mindestens einer Dekorrelationsmatrix ([G]) zwischen den gemessenen Strömen ($I_{mesi}$) und den tatsächlichen Strömen ($I_{réeli}$) in Abhängigkeit von der Position der Wandler ($C_i$) gegenüber den Leitern (i);
   - Mittel zum Erstellen einer Versatzmatrix ([0]) durch Bestimmen ihrer Elemente ($O_i$) als gleich den Strömen, die in jedem Leiter (i) in Abwesenheit von Strömen gemessen werden, die in den Leitern angelegt werden, und
   - Mittel zum Berechnen einer Matrix der tatsächlichen Ströme ($I_{réel}$), die die tatsächlichen Ströme ($I_{réeli}$) darstellt, durch Subtrahieren der Versatzmatrix ([O]) von einer Matrix ($I_{mes}$) der gemessenen Ströme ($I_{mesi}$) und durch Anwenden einer inversen Matrix ($[G]^{-1}$) der Dekorrelationsmatrix ([G]) auf das erhaltene Ergebnis.

2. Vorrichtung nach Anspruch 1, **dadurch gekennzeichnet, dass** die Dekorrelationsmatrix ([G]) Elemente ($G_{ij}$) aufweist, die bestimmt werden, indem nacheinander in jedem Leiter (j) ein kalibrierter Strom ($I_{j0}$) angelegt wird, wobei der angelegte Strom in den anderen Leitern Null ist, und indem mit Hilfe der Wandler ($C_i$) ein elektrisches Stromsignal ($I_i$) gemessen wird, das jedem Leiter (i) zugeordnet ist.

3. Vorrichtung nach Anspruch 1 oder 2, **dadurch gekennzeichnet, dass** die Magnetfeldsensoren Hall-Effekt-Sensoren sind.

4. Verwendung der Vorrichtung nach einem der Ansprüche 1 bis 3 zum Messen des elektrischen Stroms in Eingangs-/Ausgangsleitern der Pole eines Stators einer elektrischen Rotationsmaschine.

5. Verwendung nach Anspruch 4, **dadurch gekennzeichnet, dass** eine Rückprojektionsmatrix ($[C]^{-1}$) mit der inversen Matrix ($[G]^{-1}$) der Dekorrelationsmatrix multipliziert wird, um eine Einzelmatrix ($[M]= [C]^{-1}.[G]^1$) zu erstellen, die auf die gemessenen Ausgangsströme des Stators angewendet wird, um eine digitale Regelung von Strömen der elektrischen Rotationsmaschine durchzuführen.

6. Verwendung nach Anspruch 5, **dadurch gekennzeichnet, dass** vor dem Anwenden der Einzelmatrix ([M]) auf die gemessenen Ströme die Versatzmatrix ([O]) auf die gemessenen Ausgangsströme des Stators angewendet wird.

7. Verwendung der Vorrichtung nach einem der Ansprüche 1 bis 3 zum Messen des elektrischen Stroms in einem Batteriemanagementsystem.

8. Verwendung der Vorrichtung nach einem der Ansprüche 1 bis 3 zum Messen des elektrischen Stroms in einem DC/DC-Spannungswandler-System.

**Claims**

1. Device for measuring electric currents in a plurality of n rigid, rectilinear and parallel conductors (i, i=1,...,n) that are included in a power board (PCB_P) and are located in a first plane that is defined by the latter, said device comprising electric current transducers ($C_i$) taking the form of magnetic field sensors and a microcontroller (MC) containing, in a memory, computation matrices ([G],[O]) allowing the real electric currents ($I_{réeli}$) flowing through said plurality of n conductors (i, i=1,...,n) to be calculated on the basis of currents measured ($I_{mesi}$) by means of said transducers ($C_i$), the device including a control board (PCB_C) including n said transducers ($C_i$) that are located in a second plane that is defined by the former and that correspond to the n said conductors (i, i=1,...,n), respectively, said control board (PCB_C) being intended to be mounted, in a measurement position, in parallel to said power board (PCB_P) so that said transducers ($C_i$) are placed facing said respective conductors (i, i=1,...,n) and with said first and second planes positioned in parallel, and

said microcontroller (MC) including:

- means for constructing at least one decorrelation matrix ([G]) between said measured currents ($I_{mesi}$) and said real currents ($I_{réeli}$) according to the position of the transducers ($C_i$) with respect to said conductors (i);
- means for constructing one offset matrix ([0]) by determining its elements ($O_i$) as being equal to the currents measured in each conductor (i) in the absence of applied currents in said conductors; and
- means for calculating a real current ($_{Iréel}$) matrix representing said real currents ($I_{réeli}$) by subtracting said offset matrix ([0]) from a matrix ([$I_{mes}$]) of the measured currents ($I_{mesi}$) and by applying an inverse matrix ([G]$^{-1}$) of the decorrelation matrix ([G]) to the obtained result.

2. Device according to Claim 1, **characterized in that** said decorrelation matrix ([G]) includes elements ($G_{ij}$) that are determined by successively applying, in each conductor (j), a calibrated current ($I_{j0}$), the applied current in the other conductors being zero, and by measuring, by means of said transducers ($C_i$), an electric current signal ($I_i$) that is associated with each conductor (i).

3. Device according to Claim 1 or 2, **characterized in that** said magnetic field sensors are Hall effect sensors.

4. Use of the device according to any one of Claims 1 to 3 to measure the electric current in input/output conductors of the poles of a stator of a rotary electric machine.

5. Use according to Claim 4, **characterized in that** an inverse projection matrix ([C]$^{-1}$) is multiplied by said inverse matrix ([G]$^{-1}$) of the decorrelation matrix to produce a single matrix ([M] = [C]$^{-1}$.[G]$^{-1}$) that is applied to the measured output currents of the stator in order to digitally regulate the currents of said rotary electric machine.

6. Use according to Claim 5, **characterized in that**, prior to the application of the single matrix ([M]) to the measured currents, said offset matrix ([0]) is applied to the measured output currents of the stator.

7. Use of the device according to any one of Claims 1 to 3 to measure the electric current in a battery management system.

8. Use of the device according to any one of Claims 1 to 3 to measure the electric current in a (DC-to-DC) voltage converter system.

CM

CA

I    CO

**FIG. 1**

MES    MC

| i=1 | C1 |
| i=2 | C2 |
| i=3 | C3 |

CAN

**FIG. 2**

PCB_C

$C_1$    $C_2$    $C_3$

1    2    3

PCB_P

**FIG. 3**

$\varphi u$    Imesu    Ireelu    Id

$\varphi v$    + –

$\varphi w$    Imesv    Ireelv    Ig

$[G]^{-1}$    $[C]^{-1}$

+ –

+ –    Ireelw    Ih

Imesw    + –

[O]

**FIG. 4**

**FIG. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 29804737 U
- US 6472878 B
- EP 0597404 A
- US 6583613 B
- US 4933630 A
- EP 0947843 A
- DE 2845155 A